(19) **Europäisches Patentamt / European Patent Office / Office européen des brevets**

(11) **EP 3 303 723 B1**

(12) **FASCICULE DE BREVET EUROPEEN**

(45) Date de publication et mention
de la délivrance du brevet:
**30.06.2021 Bulletin 2021/26**

(21) Numéro de dépôt: **15731661.3**

(22) Date de dépôt: **26.05.2015**

(51) Int Cl.:
*E04D 3/30* (2006.01)  *F24S 25/40* (2018.01)
*H02S 20/23* (2014.01)  *H01L 31/042* (2014.01)
*H02S 40/44* (2014.01)

(86) Numéro de dépôt international:
**PCT/IB2015/000742**

(87) Numéro de publication internationale:
**WO 2016/189341 (01.12.2016 Gazette 2016/48)**

(54) **PANNEAU, ASSEMBLAGE DE PANNEAUX ET TOITURE ASSOCIÉE**

PLATTE, ANORDNUNG DER PLATTEN UND ZUGEHÖRIGES DACH

PANEL, ASSEMBLY OF PANELS, AND ASSOCIATED ROOF

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR
MA**

(43) Date de publication de la demande:
**11.04.2018 Bulletin 2018/15**

(73) Titulaire: **Arcelormittal
1160 Luxembourg (LU)**

(72) Inventeurs:
 • **VIGNAL, Renaud
 F-74320 Sévrier (FR)**
 • **GERON, Laurent
 B-4632 Cerexhe-Heuseux (BE)**
 • **WOUTERS, Paul
 B-4000 Liege (BE)**

(74) Mandataire: **Lavoix
2, place d'Estienne d'Orves
75441 Paris Cedex 09 (FR)**

(56) Documents cités:
**WO-A1-2013/029793  WO-A2-00/77860
DE-U1-202011 050 085  FR-A1- 2 951 529
US-A1- 2006 266 405  US-A1- 2009 255 530**

 • **None**

**Description**

La présente invention concerne un panneau, destiné à la réalisation d'enveloppes de bâtiments et plus particulièrement destiné à être assemblé pour permettre la construction de toitures de bâtiments porteuses de cellules photovoltaïques, sans toutefois y être limité.

Il est connu de réaliser les couvertures de toit avec des panneaux nervurés, par exemple en acier galvanisé prélaqué, dont les bords se chevauchent pour assurer l'étanchéité de la toiture.

Il est par ailleurs connu, notamment de WO2009090347, de rapporter sur la couverture des bâtiments des modules solaires, notamment photovoltaïques. Il peut s'agir notamment de modules sous forme de rubans souples collés sur la surface des creux d'onde du panneau nervuré. Dans le futur, il pourrait aussi s'agir de dispositifs photovoltaïques réalisés directement sur la surface des creux d'onde du panneau nervuré notamment par des procédés de dépôt sous vide ou à pression atmosphérique. Ces modules sont reliés entre eux par un réseau de câbles de préférence majoritairement situés en face envers de la couverture de sorte à éviter la dégradation prématurée des câbles et à préserver l'esthétique du bâtiment.

Une telle disposition présente cependant l'inconvénient de compromettre l'étanchéité de la toiture, le passage des câbles en face arrière nécessitant le plus souvent un percement en pleine face du panneau nervuré.

Une telle disposition présente également l'inconvénient de nécessiter d'avoir accès à la sous-toiture pour assurer le raccordement, en face arrière des panneaux nervurés, de deux modules successifs.

Une telle disposition présente également l'inconvénient de laisser une partie des cellules photovoltaïques dans l'ombre des nervures du panneau nervuré lorsque l'angle d'incidence des rayons du soleil sur la couverture est faible. Cela réduit en conséquence les performances du dispositif photovoltaïque. D'autres dispositifs sont connus de US2006/02466405 A1, WO2013/029793 A1, US2009/0255530 A1 ou encore WO00/77860 A2.

Par ailleurs, il y a un besoin pour des panneaux nervurés de couverture photovoltaïque facilitant l'installation de la couverture et le câblage des modules photovoltaïques.

Un but de l'invention est de pallier au problème d'étanchéité précité en proposant un panneau nervuré dont le profil est configuré de sorte que l'étanchéité soit préservée, tout en facilitant l'installation de la couverture et le câblage des modules photovoltaïques.

Un autre but de l'invention est de pallier aux problèmes des ombres portées précité en proposant un panneau nervuré dont le profil est configuré de sorte que les cellules photovoltaïques ne puissent se retrouver dans l'ombre des nervures dans la grande majorité des conditions d'éclairage.

A cet effet, l'invention a pour premier objet un panneau selon la revendication 1.

Le panneau selon l'invention peut également comprendre les caractéristiques optionnelles suivantes, prises isolément ou en combinaison :

- la première nervure longitudinale comprend un sommet de nervure de hauteur H8 et de largeur L8 et deux ailes latérales prolongeant le sommet de nervure de part et d'autre de celui-ci et vers le dessous, les deux ailes latérales formant un angle $\alpha$ avec le plan P et pour lequel la deuxième nervure longitudinale comprend un sommet de nervure de hauteur H11 et de largeur L11 et deux ailes latérales prolongeant le sommet de nervure de part et d'autre de celui-ci et vers le dessous en formant un angle $\gamma$ avec le plan P,
- les largeurs L13, L15, les hauteurs H8, H11, H16 et les angles $\alpha$, $\beta$, $\gamma$ respectent les relations suivantes :

$$H16 / H8 \geq 0{,}4$$

$$H16 \geq ((H8 \times (ab-be) - L13 \times abe) / (ae + ab))$$

$$H16 \geq ((H11 \times (cb-be) - L15 \times cbe) / (ce + cb))$$

Avec a = tan $\alpha$, b = tan $\beta$, c = tan $\gamma$ et e = tan 20°,
- le rapport de la longueur L16 sur la longueur L8 est supérieur ou égal à 5 et le rapport de la longueur L16 sur la longueur L11 est supérieur ou égal à 5,
- la partie centrale comprend au moins deux parties saillantes séparées par deux semelles intermédiaires de longueur L18 situées dans le plan P encadrant une nervure centrale comprenant un sommet de nervure de hauteur H20 et deux ailes latérales prolongeant le sommet de nervure de part et d'autre de celui-ci vers le dessous et vers l'extérieur en formant un angle $\delta$ avec le plan P,
- la largeur L18, les hauteurs H16, H20 et les angles $\beta$ et $\delta$ respectent la relation suivante :

$$H16 \geq ((H20 \times (db\text{-}be) - L18 \times dbe) / (de + db))$$

Avec $b = \tan \beta$, $d = \tan \delta$ et $e = \tan 20°$,

- le panneau présente une largeur L1 et le rapport de la somme des largeurs L16 des plateaux supérieurs sur la largeur L1 du panneau est supérieur ou égal à 0,5,
- les cellules photovoltaïques sont assemblées sous forme de rubans souples collés sur le plateau supérieur,
- les cellules photovoltaïques sont réalisées directement sur le plateau supérieur par des procédés de dépôt sous vide,
- le renfoncement s'étend jusqu'à l'arête transversale supérieure du panneau,
- le renfoncement est centré latéralement sur le plateau supérieur,
- l'ouverture est située dans la moitié supérieure de la zone de recouvrement supérieure,
- le percement est situé dans le quart inférieur de la zone de recouvrement inférieure.

L'invention a pour second objet une toiture comprenant un assemblage par recouvrement marginal d'au moins deux panneaux selon l'invention.

D'autres caractéristiques et avantages de l'invention apparaitront à la lecture de la description qui va suivre.

L'invention sera mieux comprise à la lecture de la description qui suit, donnée à titre explicatif mais non limitatif, en référence aux figures annexées qui représentent :

- La figure 1 est une vue en perspective d'un panneau selon l'invention,
- La figure 2 est une section transversale d'un panneau selon l'invention,
- La figure 3 est un détail de la figure 2,
- La figure 4 est une vue en perspective d'un panneau selon une variante de l'invention, où certaines caractéristiques telles que le renfoncement et l'ouverture avec boitier ne sont pas illustrées,
- La figure 5 est une vue en perspective de la zone de recouvrement supérieure d'un panneau selon une variante de l'invention,
- La figure 6 est une vue en perspective de la zone de recouvrement supérieure d'un panneau selon une autre variante de l'invention,
- La figure 7 est une vue en perspective de la zone de recouvrement inférieure d'un panneau selon une variante de l'invention.

Les mêmes numéros de référence représentent les mêmes éléments dans chacune des figures.

Dans l'ensemble du texte, on entendra par panneau un élément de forme plate, c'est-à-dire de faible épaisseur comparée à ses autres dimensions. Le panneau peut se présenter sous la forme d'une plaque ou d'une feuille constituée d'un matériau unique ou d'un assemblage composite. Dans ce dernier cas, le panneau est une superposition de plusieurs couches du même matériau ou de matériaux différents. Le matériau en question peut être, entre autre, un matériau métallique, un polymère ou encore une céramique. On pourra citer à titre d'exemple non limitatif de matériaux métalliques l'acier, l'aluminium, le cuivre, le zinc. De préférence le panneau est une tôle métallique. De préférence, il s'agit d'acier préalablement galvanisé et prélaqué afin de le protéger de la corrosion. Le panneau peut optionnellement être moussé.

Dans le cadre de l'invention, le panneau aura été préalablement mis en forme au moyen de tout procédé connu de mise en forme parmi lesquels on citera à titre d'exemple non limitatif le pliage, le profilage, l'emboutissage, le moulage.

Cette mise en forme conduit notamment à la formation de nervures à la surface du panneau. Dans l'ensemble du texte on entendra par nervure une saillie formée à la surface du panneau. La nervure peut être de forme trapézoïdale, comme dans le cas des exemples de réalisation présentés ci-après, ou de forme rectangulaire, ondulée, sinusoïdale ou encore en oméga, par exemple. Elle comprend un sommet de nervure et deux ailes latérales.

Pour former une toiture ou une façade, les panneaux sont assemblés par recouvrement marginal de leurs bords longitudinaux et de leurs bords transversaux et fixés à la structure porteuse du bâtiment par l'intermédiaire de moyens de fixation tels que des vis, des clous ou encore des rivets.

Dans l'ensemble du texte, on entendra par module photovoltaïque, un ensemble de cellules photovoltaïques reliées entre elles, de préférence en série, et isolées de l'extérieur par une barrière protectrice. Il peut s'agir, à titre d'exemple non limitatif, d'un module sous forme de ruban souple collé sur la partie centrale du panneau ou d'un module réalisé directement sur la partie centrale du panneau par dépôts successifs de couches de natures appropriées par des procédés de dépôt sous vide ou à pression atmosphérique.

Au sein de chaque module photovoltaïque, la disposition et l'organisation des cellules photovoltaïques n'est pas limitative. A titre d'exemple non limitatif, les cellules peuvent être disposées les unes sous les autres en une unique rangée ou peuvent être disposées en plusieurs rangées, les rangées étant reliées les unes aux autres de sorte à former une sorte de ruban plié. De préférence, et afin de faciliter la réalisation, directement sur le panneau, de modules photovoltaïques par des procédés de dépôt sous vide ou à pression atmosphérique, les cellules sont disposées en une unique rangée.

Dans le cadre de l'invention, le module photovoltaïque comprend un pôle électrique à l'une de ses extrémités longitudinales et un pôle électrique de polarité inverse à l'autre extrémité.

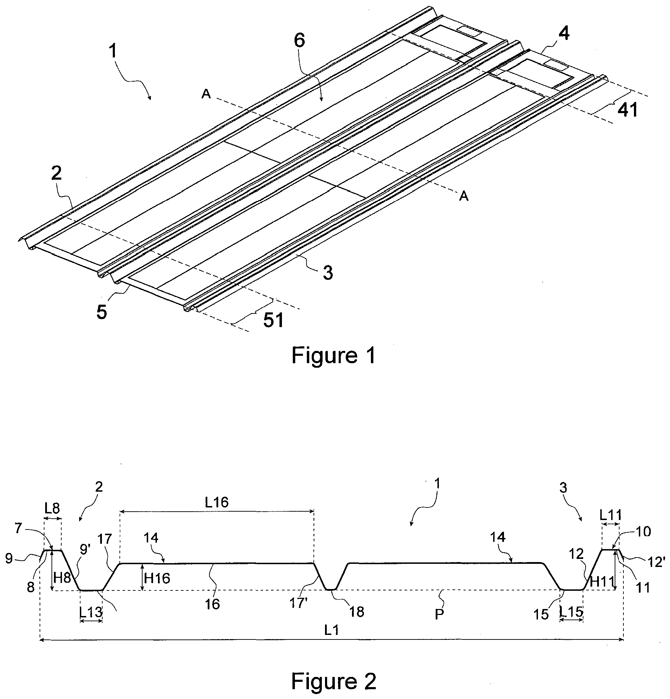

En référence à la figure 1, le panneau 1 est principalement constitué d'un premier bord longitudinal 2, d'un second bord longitudinal 3, d'un bord transversal supérieur 4, d'un bord transversal inférieur 5, les quatre bords étant reliés par une partie centrale 6 destinée à être recouverte de modules photovoltaïques.

Le bord transversal supérieur 4 comprend une zone de recouvrement supérieure 41 destinée à être recouverte par un panneau adjacent lors de l'assemblage de la toiture. Cette zone de recouvrement supérieure a généralement une largeur comprise entre 150 et 500mm en fonction, entre autre, de la pente du toit.

Le bord transversal inférieur 5 comprend une zone de recouvrement inférieure 51 destinée à recouvrir un panneau adjacent lors de l'assemblage de la toiture. Cette zone de recouvrement inférieure a généralement une largeur comprise entre 150 et 500mm en fonction, entre autre, de la pente du toit.

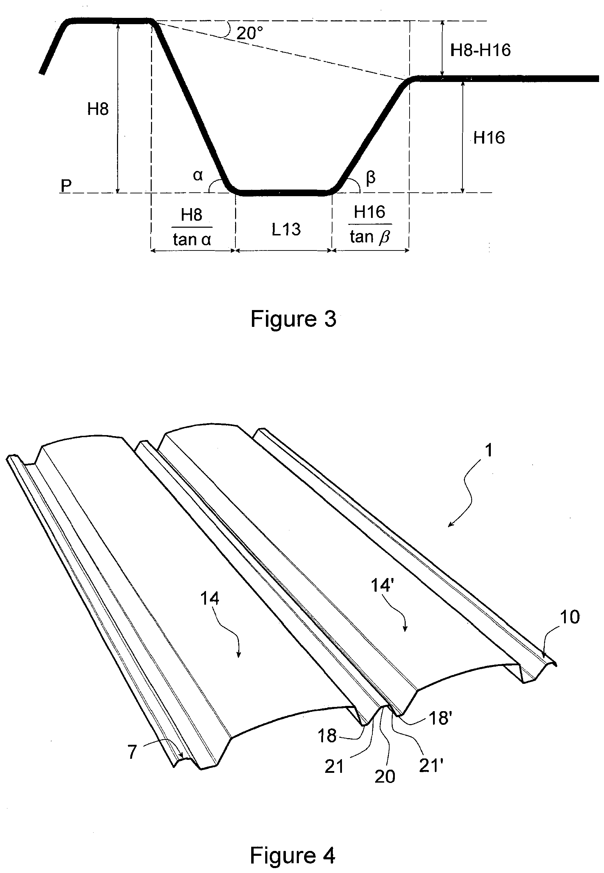

En référence aux figures 2 et 3, on décrit maintenant le premier bord longitudinal 2 et le second bord longitudinal 3. Le panneau 1 y est représenté en coupe selon la coupe transversale A-A représentée à la figure 1. Cette coupe est située en dehors des zones de recouvrement 41 et 51.

Tout d'abord, le premier bord longitudinal 2 comprend une première nervure longitudinale 7 constituée d'un sommet de nervure 8 de hauteur H8 et de largeur L8 et de deux ailes latérales 9, 9' prolongeant le sommet de nervure 8 de part et d'autre de celui-ci et vers le dessous en formant un angle $\alpha$ avec le plan P. Par hauteur H8 il faut entendre ici la distance entre le plan P et le point le plus élevé du sommet de nervure.

Le plan P est le plan dans lequel repose le panneau 1 lorsqu'il est posé à plat sur un support.

La première nervure longitudinale 7 a notamment pour fonction d'assurer la fixation du panneau à la structure du bâtiment en sommet d'onde du panneau et non en creux d'onde. Ceci permet d'éviter la stagnation d'eau au voisinage des fixations et donc d'éviter une éventuelle défaillance de l'étanchéité de la toiture.

Dans le cas de cet exemple, le sommet de nervure 8 est plan et les ailes latérales 9, 9' sont inclinées, s'étendant vers le dessous et vers l'extérieur du sommet de nervure 8, l'angle $\alpha$ étant alors aigu. Dans le cadre de l'invention, la première nervure longitudinale 7 peut bien sûr présenter d'autres formes que celle décrite dans le cas de cet exemple. L'aile latérale 9' de la nervure longitudinale 7 peut notamment être tronquée, comme dans le cas de la figure 2, ou non en fonction de la résistance mécanique souhaitée de cette partie du panneau.

Le second bord longitudinal 3 comprend une deuxième nervure longitudinale 10 constituée d'un sommet de nervure 11 de hauteur H11 et de largeur L11 et de deux ailes latérales 12, 12' prolongeant le sommet de nervure 11 de part et d'autre de celui-ci et vers le dessous en formant un angle $\gamma$ avec le plan P. Par hauteur H11 il faut entendre ici la distance entre le plan P et le point le plus élevé du sommet de nervure.

La deuxième nervure longitudinale a pour fonction d'être recouverte par la première nervure longitudinale du panneau adjacent lors de l'assemblage de deux panneaux. En conséquence, la hauteur H11 est inférieure ou égale à la hauteur H8 de la première nervure longitudinale. Les formes des première et deuxième nervures longitudinales sont ajustées en conséquence. De préférence, les formes sont ajustées de sorte que l'étanchéité à l'eau soit assurée en cas d'utilisation de panneau en toiture. De préférence, les deux nervures sont de forme et de dimensions identiques afin que le recouvrement soit parfaitement jointif et donc parfaitement étanche. Cependant, dans le cadre de l'invention, le recouvrement peut n'être que localement jointif. L'homme du métier qui connaît ces questions d'étanchéité saura adapter les formes des deux nervures longitudinales en fonction de l'esthétique recherchée tout en s'assurant de l'étanchéité de l'assemblage.

Selon l'exemple illustré aux figures 2 et 3, les deux nervures longitudinales 7, 10 sont de forme identique trapézoïdale, les ailes latérales s'étendant vers le dessous et vers l'extérieur et les ailes latérales 9, 12' étant tronquées. Le recouvrement des deux nervures longitudinales se fait ainsi de façon parfaitement jointive, ce qui contribue à l'étanchéité de la toiture.

La partie centrale 6 est située dans le prolongement de la première nervure longitudinale 7 et de la deuxième nervure longitudinale 10. Selon une première variante non revendiquée, la partie centrale 6 est plane. Selon une seconde variante non revendiquée, la partie centrale 6 est majoritairement plane et comprend des raidisseurs longitudinaux régulièrement répartis sur l'ensemble de la partie centrale.

Selon une troisième variante, selon l'invention, illustrée aux figures 2 et 4, la partie centrale 6 comprend successivement une première semelle 13, au moins une partie saillante 14 et une deuxième semelle 15. La première semelle 13, de largeur L13, est située dans le plan P dans le prolongement de l'aile latérale 9' de la première nervure longitudinale 7. La deuxième semelle 15, de largeur L15, est située dans le plan P dans le prolongement de l'aile latérale 12 de la deuxième nervure longitudinale 10. La partie saillante 14 comprenant un plateau supérieur 16 de hauteur H16 et de largeur L16 et deux âmes latérales 17, 17' prolongeant le plateau supérieur de part et d'autre de celui-ci et vers le dessous en formant un angle $\beta$ avec le plan P. Par hauteur H16 il faut entendre ici la distance entre le plan P et l'extrémité latérale du plateau supérieur, autrement dit le point d'intersection du plateau supérieur et d'une âme latérale.

La partie saillante 14 permet notamment d'intégrer un boitier de connexion et/ou des connecteurs entre le plateau supérieur 16 et le plan P. Lors de la mise en place du panneau sur la structure porteuse du bâtiment par glissement des semelles 13 et 15 sur la structure porteuse, le boitier de connexion et/ou les connecteurs ne font ainsi pas obstacle au glissement.

Selon l'exemple illustré à la figure 2, la partie centrale 6 comprend deux parties saillantes 14 séparées par une semelle intermédiaire 18. Cependant la partie centrale 6 peut comprendre un autre nombre de parties saillantes 14, séparées par des semelles intermédiaires 18.

Selon l'exemple illustré à la figure 4, la partie centrale 6 comprend deux parties saillantes 14. Elles sont séparées par deux semelles intermédiaires 18, 18' de longueur L18 situées dans le plan P encadrant une nervure centrale 19 comprenant un sommet de nervure 20 de hauteur H20 et deux ailes latérales 21, 21' prolongeant le sommet de nervure de part et d'autre de celui-ci vers le dessous et vers l'extérieur en formant un angle δ avec le plan P. Cette nervure centrale permet d'une part d'accroître la résistance mécanique du panneau et d'autre part de fixer le centre du panneau à la structure porteuse du bâtiment, les semelles 13, 13' constituant des points d'appui du panneau sur cette structure.

Le plateau supérieur 16 est recouvert de cellules photovoltaïques. Il peut s'agir par exemple de modules sous forme de rubans souples collés sur la surface du plateau supérieur 16 ou de modules photovoltaïques réalisés directement sur la surface du plateau 16 par des procédés de dépôt sous vide ou à pression atmosphérique. A cet effet, et de sorte à obtenir un taux de couverture photovoltaïque significatif, le plateau 16 est, de préférence, de grande dimension comparativement au sommet de nervure 8, 11 des nervures longitudinales et occupe une part significative du panneau. Ainsi, de préférence :

- le rapport de la largeur L16 du plateau supérieur 16 sur la largeur L8 du sommet de nervure 8 est supérieur ou égal à 5,
- le rapport de la largeur L16 du plateau supérieur 16 sur la largeur L11 du sommet de nervure 11 est supérieur ou égal à 5.

De préférence, et toujours dans un souci d'obtenir un panneau largement recouvert de cellules photovoltaïques, le rapport de la somme des largeurs L16 des plateaux supérieurs 16 de l'ensemble des parties saillantes 14 de la partie centrale 6 sur la largeur L1 du panneau est supérieur ou égal à 0,5.

L'orientation des âmes latérales 17, 17' peut également permettre d'accroitre le taux de couverture photovoltaïque. Dans le cas de la figure 2, les ailes latérales 17, 17' sont inclinées, s'étendant vers le dessous et vers l'extérieur du plateau supérieur 16. Cependant d'autres configurations sont possibles; les âmes latérales 17, 17' peuvent par exemple s'étendre vers le dessous et vers l'intérieur du plateau supérieur 16, l'angle β étant obtus, de sorte à minimiser la distance existant entre l'extrémité latérale du plateau supérieur 16 et l'extrémité latérale du sommet de nervure 8 ou 11 et ainsi maximiser la surface disponible pour les cellules photovoltaïques.

En référence à la figure 4, la portion de la partie centrale 6 située dans la zone de recouvrement supérieure 41 comprend un renfoncement 22 (non illustré sur la figure 4), autrement dit une zone de partie centrale située sous la surface du reste de la partie centrale 6. Selon l'invention, la partie centrale comprend au moins une partie saillante 14, et le renfoncement 22 est situé dans la partie du plateau supérieur 16 située dans la zone de recouvrement supérieure 41.

Ce renfoncement a vocation à permettre l'intégration du câblage électrique des modules photovoltaïques sans compromettre l'étanchéité de l'assemblage de deux panneaux adjacents. En particulier, il permet d'intégrer un boitier de connexion apte à relier électriquement, d'une part, une borne électrique d'un module photovoltaïque situé sur la partie centrale 6 du panneau et, d'autre part, la borne électrique de polarité opposée d'un module photovoltaïque situé sur la partie centrale 6 du panneau adjacent recouvrant la zone de recouvrement supérieure du premier panneau. Le renfoncement 22 permet également d'intégrer les liaisons électriques, ou connecteurs, correspondantes.

A cet effet, le renfoncement 22 ne déborde pas de la zone de recouvrement supérieure 41. Ainsi la pluie ruisselant de la toiture ne peut pas pénétrer dans le renfoncement.

De préférence, la profondeur du renfoncement est ajustée aux dimensions du boitier de connexion et des connecteurs de sorte que le panneau 1 puisse être recouvert de façon jointive, au niveau de la zone de recouvrement supérieure 41, par un panneau adjacent. En particulier, la profondeur du renfoncement est telle que le haut du boitier de connexion et le haut des connecteurs reliant le boitier de connexion aux modules photovoltaïques ne dépassent pas le pourtour du renfoncement.

Le renfoncement 22 comprend une ouverture 23 destinée à l'encastrement d'un boitier de connexion électrique. Les dimensions de l'ouverture sont adaptées au boitier de connexion électrique prévu à cet effet. En particulier, les dimensions sont ajustées en tenant compte des dilatations thermiques et des charges pouvant s'exercer sur le panneau lors de son utilisation. Selon une variante de l'invention, l'ouverture présente des dimensions 2mm plus grandes que le boitier de connexion.

De préférence, le bord transversal inférieur de l'ouverture 23 est situé au plus près de l'arête transversale supérieure du panneau. De la sorte, l'ouverture est éloignée au maximum de la limite inférieure de la zone de recouvrement supérieure 41, ce qui facilite le maintien d'une bonne étanchéité de la toiture. En effet, une éventuelle remontée de l'eau par capillarité, dans l'interstice formé par la zone de recouvrement supérieure du panneau inférieur et par la zone de recouvrement inférieure du panneau supérieure, ne risque pas d'atteindre l'ouverture. De préférence, le bord transversal inférieur de l'ouverture 23 se situe dans la moitié supérieure de la zone de recouvrement supérieure 41. Plus préférentiellement, le bord transversal inférieur de l'ouverture 23 est situé au plus à 150mm de l'arête transversale supérieure du panneau.

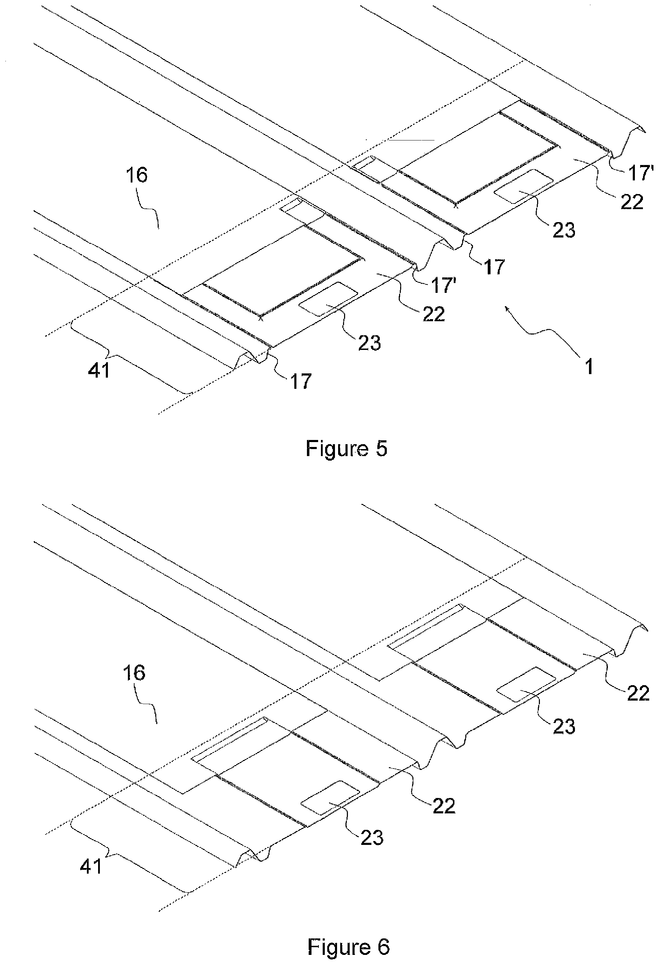

La forme du renfoncement 22 n'est pas limitative. Selon la variante présentée à la figure 5, le renfoncement présente une forme en U. L'ouverture 23 est centrée transversalement sur le plateau supérieur 16 et les branches du U s'étendent jusqu'au voisinage des âmes latérales 17, 17'. Cette forme en U permet d'encastrer le boitier de connexion en partie centrale, autrement dit de le centrer transversalement sur la partie centrale 6, ou le cas échéant sur le plateau supérieur 16, et de relier le boitier aux bords longitudinaux des modules photovoltaïques par des connecteurs disposés dans les branches du U.

Selon une autre variante de l'invention illustrée à la figure 6, le renfoncement 22 présente une forme rectangulaire et est centré transversalement sur le plateau supérieur 16. Cette forme permet d'encastrer le boitier de connexion en partie centrale et de relier le boitier aux parties centrales des modules photovoltaïques par des connecteurs disposés également en partie centrale.

Le renfoncement 22 peut être obtenu par emboutissage de la partie centrale 6 ou par toute autre technique de mise en forme connue de l'homme du métier et adaptée à la situation.

L'ouverture 23 peut être obtenue par toute technique de découpe connue de l'homme du métier, parmi lesquelles, on pourra citer, à titre d'exemples non limitatifs, le poinçonnage, le fraisage, la découpe mécanique, la découpe laser, la découpe à l'eau, l'oxycoupage.

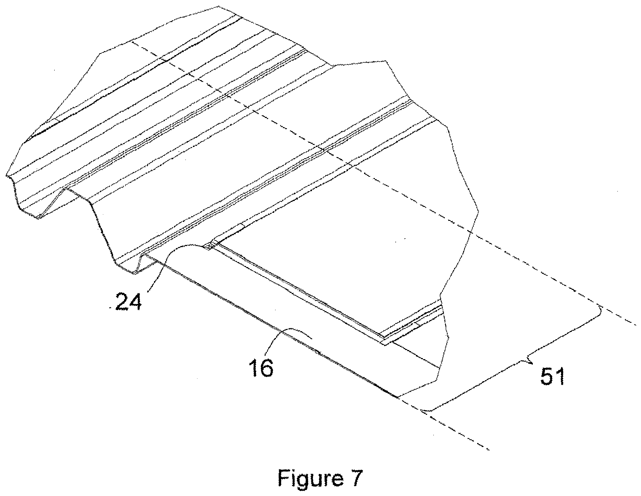

En référence à la figure 7, la portion de la partie centrale 6 située dans la zone de recouvrement inférieure 51 comprend un percement 24, c'est-à-dire une ouverture pratiquée dans l'épaisseur de la partie centrale. Selon l'invention, la partie centrale comprend au moins une partie saillante 14, et le percement 24 est situé dans la partie du plateau supérieur 16 située dans la zone de recouvrement inférieure 51.

Ce percement a vocation à permettre l'intégration du câblage électrique des modules photovoltaïques sans compromettre l'étanchéité de l'assemblage de deux panneaux adjacents. En particulier, le percement 24 permet de faire passer en face arrière du panneau la liaison électrique reliant une des bornes électriques du module photovoltaïque au boitier de connexion encastré dans l'ouverture 23 du panneau adjacent dont la zone de recouvrement inférieure est située sous le percement.

A cet effet, le percement ne déborde pas de la zone de recouvrement inférieure 51. Ainsi si la pluie ruisselant de la toiture était amenée à traverser le percement suite à une mauvaise étanchéification de celui-ci, l'eau se retrouverait contenue par la zone de recouvrement supérieure 41 du panneau adjacent et continuerait à s'écouler le long de la toiture. L'étanchéité de la toiture est ainsi préservée.

Selon une variante de l'invention, le percement 24 se situe au plus près de l'arête transversale inférieure du panneau, de préférence dans le quart inférieur de la zone de recouvrement inférieure 51 du panneau. De la sorte, le percement est éloigné au maximum de l'arête transversale supérieure du panneau adjacent partiellement recouvert par la zone de recouvrement inférieure du panneau, ce qui facilite le maintien d'une bonne étanchéité de l'assemblage des panneaux. En effet, une éventuelle remontée de l'eau par capillarité depuis l'envers d'un percement 24 à l'étanchéité déficiente d'un premier panneau ne risque pas d'atteindre l'ouverture 23, très éloignée, d'un second panneau partiellement recouvert par le premier panneau.

Selon une autre variante de l'invention, le percement 24 se situe dans les deux tiers supérieurs de la zone de recouvrement inférieure 51 du panneau. Le percement 24 est alors largement recouvert par les cellules photovoltaïques, ce qui contribue à la bonne étanchéité au niveau du percement. De préférence, le percement 24 est positionné de sorte à être à l'aplomb de l'ouverture 23 d'un panneau adjacent lorsque la zone de recouvrement inférieure 51 du panneau vient recouvrir la zone de recouvrement supérieure 41 du panneau adjacent. Un tel positionnement permet de simplement relier électriquement les deux panneaux sans recourir à une liaison électrique sophistiquée.

La géométrie et les dimensions du percement 23 ne sont pas limitatives. Elles sont ajustées de sorte que le percement puisse être recouvert :

- en face supérieure, par un module photovoltaïque, la liaison entre la face supérieure et le module photovoltaïque, telle qu'un adhésif, faisant office de membrane d'étanchéité sur le pourtour du percement,
- en face inférieure, par un connecteur, la liaison entre la face inférieure et le connecteur, telle qu'un adhésif, faisant office de membrane d'étanchéité sur le pourtour du percement,

Selon une variante, le percement est un petit rectangle dont les dimensions sont adaptées aux connecteurs déjà existants sur le marché.

De préférence, le positionnement latéral du percement 23 est ajusté de sorte que le percement se trouve à l'aplomb d'une borne électrique du module photovoltaïque recouvrant la partie centrale 6 ou, le cas échéant, le plateau supérieur 16.

Le percement 23 peut être obtenu par toute technique de découpe connue de l'homme du métier, parmi lesquelles, on pourra citer, à titre d'exemples non limitatifs, le poinçonnage, le fraisage, la découpe mécanique, la découpe laser, la découpe à l'eau, l'oxycoupage.

Selon l'invention, la partie centrale 6 comprend au moins une partie saillante 14, et le profil du panneau 1 est par ailleurs configuré de sorte que les cellules photovoltaïques ne puissent se retrouver dans l'ombre des nervures dans la grande majorité des conditions d'éclairage.

En particulier, la hauteur du plateau supérieur, la hauteur des parties centrales supérieures, la largeur des semelles et les angles $\alpha$, $\beta$ et $\gamma$ sont configurés de sorte qu'aucune portion des cellules photovoltaïques recouvrant le plateau supérieur ne puisse se retrouver à l'ombre des première et deuxième nervures longitudinales quand les rayons du soleil font un angle supérieur ou égal à 20° avec le plan P. A cet effet, dans le cadre de l'invention :

$$H16\ /H8 \geq 0{,}4 \qquad\qquad (1)$$

$$H16 \geq ((H8 \times (ab\text{-}be) - L13 \times abe)\ /\ (ae + ab)) \qquad\qquad (2)$$

- et

$$H16 \geq ((H11 \times (cb\text{-}be) - L15 \times cbe)\ /\ (ce + cb)) \qquad\qquad (3)$$

avec a = tan $\alpha$, b = tan $\beta$, c = tan $\gamma$ et e = tan 20°

les inéquations (2) et (3) résultant de l'expression de la tangente de l'angle de 20° tel que représenté à la figure 5.

L'angle de 20° correspond à la limite acceptable en terme de pertes énergétiques dues à l'ombrage ; ces pertes ne représentent alors qu'un faible pourcentage de l'énergie reçue par les cellules photovoltaïques.

Pour un ratio H16 / H8 inférieur à 0,4, le respect des inéquations (2) et (3) nécessite de recourir à des semelles 13 et 15 de grande largeur, ce qui s'avère être peu compatible avec le souci d'obtenir un panneau largement recouvert de cellules photovoltaïques.

Selon une variante, les ratios H16 / H8 et H16 / H11 sont inférieurs ou égaux à 0,6 de sorte que la majeure partie du plateau supérieur 16 ne dépasse pas au-dessus du sommet de nervure 8, 11 même lorsque le plateau supérieur est cintré, comme décrit ultérieurement. Ainsi l'étanchéité de la toiture est mieux préservée, l'eau s'écoulant du plateau supérieur ne pouvant atteindre les bords longitudinaux du panneau, au niveau du recouvrement marginal entre deux panneaux.

De préférence, les inéquations (2) et (3) sont satisfaites pour e = tan 15° et plus préférentiellement encore pour e = tan 10°. Ainsi les cellules photovoltaïques recouvrant le plateau supérieur ne se retrouvent pas à l'ombre des première et deuxième nervures longitudinales quand les rayons du soleil sont particulièrement rasants.

De façon plus préférentielle encore, les cellules photovoltaïques recouvrant le plateau supérieur ne se retrouvent jamais à l'ombre des première et deuxième nervures longitudinales quelque soit l'incidence des rayons du soleil. Cette condition est satisfaite lorsque la hauteur H16 du plateau supérieur 16 est supérieure ou égale à la hauteur H8 du sommet de nervure 8 et est supérieure ou égale à la hauteur H11 du sommet de nervure 11. Autrement dit, cette condition est satisfaite lorsque les inéquations (1) à (3) sont remplacées par les inéquations suivantes :

-
$$H16 \geq H8 \qquad\qquad (4)$$

- et

$$H16 \geq H11 \qquad\qquad (5)$$

De façon plus préférentielle encore, la hauteur H16 du plateau supérieur 16 est strictement supérieure à la hauteur H8 du sommet de nervure 8 et est strictement supérieure à la hauteur H11 du sommet de nervure 11. Autrement dit, cette condition est satisfaite lorsque les inéquations (1) à (3) sont remplacées par les inéquations suivantes :

-
$$H16 > H8 \qquad\qquad (6)$$

- et

$$H16 > H11 \qquad (7)$$

Ainsi, non seulement les cellules photovoltaïques recouvrant le plateau supérieur ne se retrouvent jamais à l'ombre des première et deuxième nervures longitudinales quelque soit l'incidence des rayons du soleil, mais de plus une telle configuration permet d'envisager l'ajout de cellules photovoltaïques dans la partie supérieure des âmes latérales 17, 17' de la partie saillante 14, autrement dit dans la partie des âmes latérales qui ne se retrouve jamais dans l'ombre des nervures longitudinales. Ceci permet d'augmenter le taux de couverture photovoltaïque du panneau. Par ailleurs, le nettoyage des cellules photovoltaïques s'en trouve facilité, les nervures longitudinales ne faisant pas obstacle entre les cellules photovoltaïques de deux plateaux adjacents.

Selon la variante de l'invention selon laquelle la partie centrale 6 comprend deux parties saillantes 14 séparées par deux semelles 18, 18' et une nervure centrale 19, les semelles et la nervure centrale sont, de préférence, configurées de sorte que les cellules photovoltaïques recouvrant le plateau supérieur 16 ne puissent se retrouver à l'ombre de la nervure centrale quand les rayons du soleil font un angle supérieur ou égal à 20° avec le plan P. A cet effet, la largeur L18, les hauteurs H16, H20 et les angles $\beta$ et $\delta$ respectent la relation suivante :

$$H16 \geq ((H20 \times (db-be) - L18 \times dbe) / (de + db)) \qquad (8)$$

Avec b = tan $\beta$, d = tan $\delta$ et e = tan 20°

Selon une variante, le ratio H16 / H20 est supérieur à 0,4, ce qui évite de recourir à des semelles 18 de trop grande largeur.

Selon une variante, le ratio H16 / H20 est inférieur ou égal à 0,6 de sorte que la majeure partie du plateau supérieur ne dépasse pas au-dessus du sommet de nervure 20 de la nervure 19 même lorsque le plateau supérieur 16 est cintré. Ainsi l'étanchéité de la toiture est mieux préservée, l'eau s'écoulant du plateau supérieur ne pouvant atteindre le sommet de nervure 20 où sont situés les moyens de fixation du panneau à la structure porteuse du bâtiment.

De préférence, l'inéquation (8) est satisfaite pour e = tan 15°, et plus préférentiellement encore pour e = tan 10°. Ainsi les cellules photovoltaïques recouvrant le plateau supérieur ne se retrouvent pas à l'ombre de la nervure centrale quand les rayons du soleil sont particulièrement rasants.

De façon plus préférentielle encore, les cellules photovoltaïques recouvrant le plateau supérieur ne se retrouvent jamais à l'ombre de la nervure centrale quelque soit l'incidence des rayons du soleil. Cette condition est satisfaite lorsque l'inéquation (8) est exprimée de la façon suivante :

-

$$H16 \geq H20$$

De façon plus préférentielle encore, la hauteur H16 du plateau supérieur 16 est strictement supérieure à la hauteur H20 du sommet de nervure 20. Ainsi, non seulement les cellules photovoltaïques recouvrant le plateau supérieur ne se retrouvent jamais à l'ombre de la nervure centrale quelque soit l'incidence des rayons du soleil, mais de plus une telle configuration permet d'envisager l'ajout de cellules photovoltaïques dans la partie supérieure des âmes latérales 17, 17' de la partie saillante 14, autrement dit dans la partie des âmes latérales qui ne se retrouve jamais dans l'ombre de la nervure centrale. Ceci permet d'augmenter le taux de couverture photovoltaïque du panneau. Par ailleurs, le nettoyage des cellules photovoltaïques s'en trouve facilité, la nervure centrale 19 ne faisant pas obstacle entre les cellules photovoltaïques de deux plateaux adjacents.

Dans l'exemple illustré à la figure 4, le sommet de nervure 20 de la nervure centrale est de même hauteur que le sommet de nervure 8 de la première nervure longitudinale.

De préférence, et toujours dans un souci d'éviter les ombres portées sur les cellules photovoltaïques, le plateau supérieur 14 est plan et horizontal comme illustré à la figure 2. On est ainsi assuré qu'aucune portion du plateau ne fera d'ombre à une autre portion du plateau. Cependant, dans le cadre de l'invention, le plateau peut n'être qu'approximativement plan, autrement dit légèrement concave ou légèrement convexe. Par « légèrement concave » et « légèrement convexe » on entend ici que le cintrage du plateau est tel qu'aucune portion du plateau ne fait d'ombre à une autre portion du plateau quand les rayons du soleil font un angle supérieur ou égal à 20° avec le plan P. Ceci correspond à un rayon de courbure du plateau supérieur ou égal à 1,4 fois la largeur L14 du plateau supérieur, soit par exemple un rayon de courbure de 400mm pour une largeur L14 de l'ordre de 275mm. Ce cintrage du plateau permet de renforcer la résistance mécanique de la partie saillante. Le plateau supérieur est rigidifié et ne s'affaisse ainsi pas en cas de charge.

Selon l'exemple illustré à la figure 4, le plateau supérieur est légèrement concave avec un rayon de courbure du plateau environ égal à 1,8 fois la largeur L16 du plateau supérieur.

Il va de soi que les caractéristiques présentées à l'appui des variantes sont indépendantes les unes des autres et qu'en conséquence d'autres combinaisons de ces caractéristiques, autrement dit d'autres profils de panneau, sont possibles, dans les limites définies par les revendications.

**Revendications**

1. Panneau (1) comprenant :

   - un bord transversal supérieur (4) comprenant une zone de recouvrement supérieure (41) destinée à être recouverte par un panneau (1) adjacent,
   - un bord transversal inférieur (5) comprenant une zone de recouvrement inférieure (51) destinée à recouvrir un panneau (1) adjacent,
   - un premier bord longitudinal (2) comprenant une première nervure longitudinale (7),
   - une partie centrale (6), dans le prolongement de la première nervure longitudinale, comprenant :

     ∘ successivement :

       ▪ une première semelle (13) de largeur L13,
       ▪ au moins une partie saillante (14) comprenant un plateau supérieur (16), de hauteur H16 et de largeur L16, recouvert de cellules photovoltaïques et deux âmes latérales (17, 17') prolongeant le plateau supérieur de part et d'autre de celui-ci et vers le dessous en formant un angle β avec un plan P et
       ▪ une deuxième semelle (15) de largeur L15, la première semelle et la deuxième semelle étant situées dans le plan P,

     ∘ un renfoncement (22) situé dans la partie du plateau supérieur (16) située dans la zone de recouvrement supérieure (41) et comprenant une ouverture (23) dans laquelle un boitier de connexion électrique est encastré,
     ∘ un percement (24), situé dans la zone de recouvrement inférieure (51), pour le passage d'un connecteur électrique,

   - un second bord longitudinal (3) dans le prolongement de la partie centrale (6) et comprenant une deuxième nervure longitudinale (10), la première nervure longitudinale (7) et la deuxième nervure longitudinale (10) présentant des formes permettant leur recouvrement respectif.

2. Panneau selon la revendication 1 pour lequel la première nervure longitudinale (7) comprend un sommet de nervure (8) de hauteur H8 et de largeur L8 et deux ailes latérales (9, 9') prolongeant le sommet de nervure de part et d'autre de celui-ci et vers le dessous, les deux ailes latérales formant un angle α avec le plan P et pour lequel la deuxième nervure longitudinale (10) comprend un sommet de nervure (11) de hauteur H11 et de largeur L11 et deux ailes latérales (12, 12') prolongeant le sommet de nervure de part et d'autre de celui-ci et vers le dessous en formant un angle γ avec le plan P.

3. Panneau selon la revendication 2 pour lequel les largeurs L13, L15, les hauteurs H8, H11, H16 et les angles α, β, γ respectent les relations suivantes :

$$H16 / H8 \geq 0{,}4$$

$$H16 \geq ((H8 \times (ab\text{-}be) - L13 \times abe) / (ae + ab))$$

$$H16 \geq ((H11 \times (cb\text{-}be) - L15 \times cbe) / (ce + cb))$$

Avec a = tan α, b = tan β, c = tan γ et e = tan 20°.

4. Panneau selon la revendication 2 pour lequel le rapport de la longueur L16 sur la longueur L8 est supérieur ou égal à 5 et le rapport de la longueur L16 sur la longueur L11 est supérieur ou égal à 5.

5. Panneau selon la revendication 1 pour lequel la partie centrale (6) comprend au moins deux parties saillantes (14) séparées par deux semelles intermédiaires (18, 18') de longueur L18 situées dans le plan P encadrant une nervure centrale (19) comprenant un sommet de nervure (20) de hauteur H20 et deux ailes latérales (21, 21') prolongeant le sommet de nervure de part et d'autre de celui-ci vers le dessous et vers l'extérieur en formant un angle δ avec le plan P.

6. Panneau selon la revendication 5 pour lequel la largeur L18, les hauteurs H16, H20 et les angles β et δ respectent la relation suivante :

$$H16 \geq ((H20 \times (db\text{-}be) - L18 \times dbe) / (de + db))$$

Avec b = tan β, d= tan δ et e = tan 20°.

7. Panneau selon l'une des revendications 1 à 6, présentant une largeur L1, pour lequel le rapport de la somme des largeurs L16 des plateaux supérieurs (16, 16') sur la largeur L1 du panneau est supérieur ou égal à 0,5.

8. Panneau selon la revendication 1 pour lequel les cellules photovoltaïques sont assemblées sous forme de rubans souples collés sur le plateau supérieur (16).

9. Panneau selon la revendication 1 pour lequel les cellules photovoltaïques sont réalisées directement sur le plateau supérieur (16) par des procédés de dépôt sous vide.

10. Panneau selon l'une quelconque des revendications précédentes pour lequel le renfoncement (22) s'étend jusqu'à l'arête transversale supérieure du panneau.

11. Panneau selon la revendication 1 pour lequel le renfoncement (22) est centré latéralement sur le plateau supérieur (16).

12. Panneau selon l'une quelconque des revendications précédentes pour lequel l'ouverture (23) est située dans la moitié supérieure de la zone de recouvrement supérieure (41).

13. Panneau selon l'une quelconque des revendications précédentes pour lequel le percement (24) est situé dans le quart inférieur de la zone de recouvrement inférieure (51).

14. Toiture comprenant un assemblage par recouvrement marginal d'au moins deux panneaux selon l'une quelconque des revendications précédentes.

**Patentansprüche**

1. Paneel (1), welches aufweist:

   - einen oberen Quer-Rand (4), welcher eine obere Bedecken-Zone (41) aufweist, welche dazu bestimmt ist, von einem angrenzenden Paneel (1) bedeckt zu sein,
   - einen unteren Quer-Rand (5), welcher eine untere Bedecken-Zone (51) aufweist, welche dazu bestimmt ist, ein angrenzendes Paneel (1) zu bedecken,
   - einen ersten Längsrand (2), welcher eine erste Längsrippe (7) aufweist,
   - einen zentralen Abschnitt (6) in der Verlängerung der ersten Längsrippe, welcher aufweist:

     ∘ der Reihe nach:

       • eine erste Sohle (13) mit der Breite L13,
       • zumindest einen vorstehenden Teil (14), welcher ein oberes Plateau (16) mit der Höhe H16 und der Breite L16 aufweist, welcher von Photovoltaikzellen bedeckt ist, und zwei seitliche Stege (17, 17'), welche das obere Plateau auf beiden Seiten davon und nach unten hin unter Ausbildung eines Winkels β mit einer Ebene P verlängern, und
• eine zweite Sohle (15) mit der Breite L15, wobei die erste Sohle und die zweite Sohle in der Ebene P angeordnet sind,

 ∘ eine Verstärkung (22), welche im Abschnitt des oberen Plateaus (16), welcher in der oberen Bedecken-Zone (41) angeordnet ist, angeordnet ist und welche eine Öffnung (23) aufweist, in welcher ein Elektrische-Verbindung-Gehäuse eingebettet ist,
 ∘ einen Durchbruch (24), welcher in der unteren Bedecken-Zone (51) angeordnet ist, für das Durchführen eines elektrischen Verbinders,

- einen zweiten Längsrand (3) in der Verlängerung des zentralen Abschnitts (6), welcher eine zweite Längsrippe (10) aufweist, wobei die erste Längsrippe (7) und die zweite Längsrippe (10) Formen haben, welche ihre jeweilige Bedeckung erlauben.

2. Paneel gemäß Anspruch 1, wobei die erste Längsrippe (7) aufweist einen Rippe-Gipfel (8) mit der Höhe H8 und der Breite L8 und zwei seitliche Flügel (9, 9'), welche den Rippe-Gipfel auf beiden Seiten davon und nach unten hin verlängern, wobei die beiden seitlichen Flügel einen Winkel α mit der Ebene P bilden, und wobei die zweite Längsrippe (10) aufweist einen Rippe-Gipfel (11) mit der Höhe H11 und der Breite L11 und zwei seitliche Flügel (12, 12'), welche den Rippe-Gipfel auf beiden Seiten davon und nach unten hin unter Ausbildung eines Winkels γ mit der Ebene P verlängern.

3. Paneel gemäß Anspruch 2, wobei die Breiten L13, L15, die Höhen H8, H11, H16 und die Winkel α, β, γ die folgenden Relationen einhalten:

$$H16 / H8 \geq 0,4$$

$$H16 \geq ((H8 \times (ab\text{-}be) - L13 \times abe) / (ae + ab))$$

$$H16 \geq ((H11 \times (cb\text{-}be) - L15 \times cbe) / (ce + cb))$$

mit a = tan α, b = tan β, c = tan γ und e = tan 20°.

4. Paneel gemäß Anspruch 2, wobei das Verhältnis der Länge L16 über der Länge L8 größer oder gleich 5 ist und das Verhältnis der Länge L16 über der Länge L11 größer oder gleich 5 ist.

5. Paneel gemäß Anspruch 1, wobei der zentrale Abschnitt (6) zumindest zwei vorstehende Abschnitte (14) aufweist, welche mittels zweier Zwischensohlen (18, 18') mit der Länge L18 getrennt sind, welche in der Ebene P angeordnet sind und welche eine zentrale Rippe (19) einfassen, welche aufweist einen Rippe-Gipfel (20) mit der Höhe H20 und zwei seitliche Flügel (21, 21'), welche den Rippe-Gipfel auf beiden Seiten davon und nach unten hin und nach außen hin unter Ausbildung eines Winkels δ mit der Ebene P verlängern.

6. Paneel gemäß Anspruch 5, wobei die Länge L18, die Höhen H16, H20 und die Winkel β und δ die folgenden Relationen einhalten:

$$H16 \geq ((H20 \times (db\text{-}be) - L18 \times dbe) / (de + db))$$

mit b = tan β, d = tan δ und e = tan 20°.

7. Paneel gemäß einem der Ansprüche 1 bis 6, welches eine Länge L1 hat, wobei das Verhältnis der Summe der Längen L16 der oberen Plateaus (16, 16') über der Länge L1 des Paneels größer oder gleich 0,5 ist.

8. Paneel gemäß Anspruch 1, wobei die Photovoltaik-Zellen in Form von biegsamen Bändern zusammengebaut sind, welche auf das obere Paneel (16) geklebt sind.

9. Paneel gemäß Anspruch 1, wobei die Photovoltaik-Zellen direkt auf dem oberen Paneel (16) mittels Vakuumablagerungsverfahren hergestellt sind.

10. Paneel gemäß irgendeinem der vorherigen Ansprüche, wobei sich die Verstärkung (22) bis zur oberen Quer-Kante des Paneels hin erstreckt.

11. Paneel gemäß Anspruch 1, wobei die Verstärkung (22) auf dem oberen Plateau (16) seitlich zentriert ist.

12. Paneel gemäß irgendeinem der vorherigen Ansprüche, wobei die Öffnung (23) in der oberen Hälfte der oberen Bedecken-Zone (41) angeordnet ist.

13. Paneel gemäß irgendeinem der vorherigen Ansprüche, wobei der Durchbruch (24) im unteren Viertel der unteren Bedecken-Zone (51) angeordnet ist.

14. Dach, welches eine Anordnung mittels marginaler Bedeckung von zumindest zwei Paneelen gemäß irgendeinem der vorherigen Ansprüche aufweist.


**Claims**

1. Panel (1) comprising:

   - an upper transverse edge (4) including an upper overlap area (41) intended to be covered by an adjacent panel (1),
   - a lower transverse edge (5) including a lower overlap area (51) intended to cover an adjacent panel (1),
   - a first longitudinal edge (2) including a first longitudinal rib (7),
   - a central part (6) extending from the first longitudinal rib, comprising:

     ◦ successively:

        ▪ a first base plate (13) of width L13,
        ▪ at least one projecting part (14) comprising an upper plate (16) of height H16 and width L16, covered with photovoltaic cells and two side web plates (17, 17') extending from the upper plate on both sides thereof and downward at an angle $\beta$ with plane P and
        ▪ a second base plate (15) of width L15, the first base plate and the second base plate being located in a plane P

     ◦ a recess (22) located in the part of the upper plate (16) located in the upper overlap area (41) and comprising an opening (23) in which an electrical junction box is mounted,
     ◦ a perforation (24) in the lower overlap area (51) for passing through an electrical connector,

   - a second longitudinal edge (3) extending from central part (6) and comprising a second longitudinal rib (10), the first longitudinal rib (7) and the second longitudinal rib (10) having shapes enabling them to overlap.

2. Panel according to Claim 1, wherein first longitudinal rib (7) comprises a rib apex (8) of height H8 and width L8 and two lateral base plates (9, 9') extending from the rib apex on both sides thereof and downward, the two lateral base plates forming an angle $\alpha$ with plane P and wherein the second longitudinal rib (10) comprises a rib apex (11) of height H11 and width L11, and two lateral base plates (12,12') extending from the rib apex on both sides thereof and downward to form an angle $\gamma$ with plane P.

3. Panel according to Claim 2, wherein widths L13, L15, heights H8, H11, H16 and angles $\alpha$, $\beta$, $\gamma$ satisfy the following relations

$$H16 / H8 \geq 0,4$$

$$H16 \geq ((H8 \times (ab-be) - L13 \times abe) / (ae + ab))$$

$$H16 \geq ((H11 \times (cb\text{-}be) - L15 \times cbe) / (ce + cb))$$

With a = tan $\alpha$, b = tan $\beta$, c = tan $\gamma$ and e = tan 20°.

4. Panel according to Claim 2, wherein the ratio of length L16 to length L8 is greater than or equal to 5 and the ratio of length L16 to length L11 is greater than or equal to 5.

5. Panel according to Claim 1, wherein central part (6) comprises at least two projecting parts (14) separated by two intermediate base plates (18, 18') of length L18 located in plane P framing a central rib (19) comprising a rib apex (20) of height H20 and two lateral base plates (21, 21') extending from the rib apex on both sides thereof downward and outward forming an angle $\delta$ with plane P.

6. Panel according to Claim 5, wherein width L18, heights H16, H20 and angles $\beta$ and $\delta$ satisfy the following relation:

$$H16 \geq ((H20 \times (db\text{-}be) - L18 \times dbe) / (de + db))$$

With b = tan $\beta$, d= tan $\delta$ and e = tan 20°.

7. Panel according to any of Claims 1 to 6, having a width L1, wherein the ratio of the sum of widths L16 of the upper plates (16.16') to the width L1 of the panel is greater than or equal to 0.5.

8. Panel according to Claim 1, wherein photovoltaic cells are assembled in the form of flexible strips glued to the upper plate (16).

9. Panel according to Claim 1, wherein photovoltaic cells are built directly on upper plate (16) by vacuum deposition methods.

10. Panel according to any of the above claims, wherein recess (22) extends to the upper transverse edge of the panel.

11. Panel according to Claim 1, wherein recess (22) is laterally centered on upper plate (16).

12. Panel according to any of the above claims, wherein opening (23) is located in the upper half of the upper overlap area (41).

13. Panel according to any of the above claims, wherein perforation (24) is located in the lower quarter of the lower overlap area (51).

14. Roof comprising a marginal overlap assembly of at least two panels according to any of the above claims.

Figure 1

Figure 2

20°

H8−H16

H8

H16

P

α

β

$\dfrac{H8}{\tan\alpha}$

L13

$\dfrac{H16}{\tan\beta}$

Figure 3

1

14

14'

10

7

18

18'

21

20

21'

Figure 4

**Figure 5**

**Figure 6**

24

16

51

Figure 7

**EP 3 303 723 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009090347 A
- US 200602466405 A1
- WO 2013029793 A1
- US 20090255530 A1
- WO 0077860 A2